# EUROPEAN PATENT APPLICATION

(11) **EP 3 460 837 A1**
(43) Date of publication of application: **27.03.2019**
(21) Application number: 17193284.1
(22) Date of filing: 26.09.2017
(51) Int. Cl.: H01L 23/043, H01L 23/10, H01L 25/07, H01L 23/373

(54) **A HOUSING FOR A POWER SEMICONDUCTOR MODULE, A POWER SEMICONDUCTOR MODULE AND A METHOD FOR PRODUCING THE SAME**

(71) Applicant: Infineon Technologies AG, 85579 Neubiberg (DE)
(72) Inventor: Hartung, Hans, 59581 Warstein (DE)
(74) Representative: Westphal, Mussgnug & Partner Patentanwälte mbB

(57) **Abstract**

A power semiconductor module comprises at least one semiconductor substrate comprising a dielectric insulation layer, a first metallization layer attached to the dielectric insulation layer, and a second metallization layer attached to the dielectric insulation layer, wherein the dielectric insulation layer is disposed between the first and second metallization layers. A power semiconductor arrangement is arranged on the at least one semiconductor substrate, wherein the power semiconductor arrangement includes at least one first terminal element and wherein the first terminal element is connected to the semiconductor substrate with a first end. The power semiconductor module further comprises a base plate, wherein the semiconductor substrate is arranged on the base plate, a housing that is configured to enclose the semiconductor substrate and that is configured to be connected to the base plate, the housing comprising sidewalls and a cover, wherein the cover comprises an opening, and a second terminal element that is arranged within the opening in the cover of the housing such that a first end of the second terminal element protrudes into the housing, the first end being configured to be electrically and mechanically connected to a second end of the first terminal element to form a contact element, and such that a second end of the second terminal element protrudes out of the housing to allow the contact element to be electrically contacted from the outside. A first seal is arranged within the opening in the cover of the housing, the first seal being configured to seal the opening such that gases are prevented from entering the housing through the opening.

## Description

### TECHNICAL FIELD

The instant disclosure relates to a housing for a power semiconductor module and a power semiconductor module, in particular a sealed and leakproof power semiconductor module, and a method for producing such power semiconductor module.

### BACKGROUND

Power semiconductor modules often include at least one semiconductor substrate arranged in a housing. A semiconductor arrangement including a plurality of controllable semiconductor elements (e.g., two IGBTs in a half-bridge configuration) may be arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may be attached to a base plate. The controllable semiconductor devices are usually mounted to the semiconductor substrate by soldering or sintering techniques.

Electrical lines or electrical connections are used to connect different semiconductor devices. Such electrical lines and electrical connections may include metal and/or semiconductor material. Power semiconductor modules are often exposed to gases such as corrosive gases, for example. Some gases such as sulfur containing gases, for example, may react with metallic components inside the housing. This leads to a chemical degradation of these components which may result in a failure of individual components and ultimately of the whole semiconductor arrangement.

There is a need for a housing that protects the semiconductor components against corrosion such that the overall lifetime of the power semiconductor module is increased.

### SUMMARY

A power semiconductor module comprises at least one semiconductor substrate comprising a dielectric insulation layer, a first metallization layer attached to the dielectric insulation layer, and a second metallization layer attached to the dielectric insulation layer, wherein the dielectric insulation layer is disposed between the first and second metallization layers. A power semiconductor arrangement is arranged on the at least one semiconductor substrate, wherein the power semiconductor arrangement includes at least one first terminal element and wherein the first terminal element is connected to the semiconductor substrate with a first end. The power semiconductor module further comprises a base plate, wherein the semiconductor substrate is arranged on the base plate, a housing that is configured to enclose the semiconductor substrate and that is configured to be connected to the base plate, the housing comprising sidewalls and a cover, wherein the cover comprises an opening, and a second terminal element that is arranged within the opening in the cover of the housing such that a first end of the second terminal element protrudes into the housing, the first end being configured to be electrically and mechanically connected to a second end of the first terminal element to form a contact element, and such that a second end of the second terminal element protrudes out of the housing to allow the contact element to be electrically contacted from the outside. A first seal is arranged within the opening in the cover of the housing, the first seal being configured to seal the opening such that gases are prevented from entering the housing through the opening.

A housing for a power semiconductor module is configured to be connected to a base plate and to enclose a power semiconductor arrangement arranged on a substrate. The housing comprises sidewalls, a cover with an opening and a second terminal element that is arranged within the opening in the cover of the housing such that a first end of the second terminal element protrudes into the housing, the first end being configured to be electrically and mechanically connected to a second end of a first terminal element of the power semiconductor arrangement to form a contact element, and such that a second end of the second terminal element protrudes out of the housing to allow the contact element to be electrically contacted from the outside. A first seal is arranged within the opening in the cover of the housing, the first seal being configured to seal the opening such that gases are prevented from entering the housing through the opening.

A method for producing a power semiconductor module arrangement includes arranging a power semiconductor arrangement on at least one semiconductor substrate, wherein the semiconductor substrate comprises a dielectric insulation layer, a first metallization layer attached to the dielectric insulation layer, and a second metallization layer attached to the dielectric insulation layer, the dielectric insulation layer being disposed between the first and second metallization layers, and wherein the power semiconductor arrangement includes at least one first terminal element that is connected to the semiconductor substrate with a first end. The method further comprises mounting the semiconductor substrate to a base plate, placing the base plate with the semiconductor substrate in a vacuum chamber, forming a casting compound covering the power semiconductor arrangement arranged on the semiconductor substrate, and mounting a housing to the base plate such that it encloses the semiconductor substrate. The housing comprises sidewalls, a cover with an opening, and a second terminal element that is arranged within the opening in the cover of the housing such that a first end of the second terminal element protrudes into the housing, the first end being configured to be electrically and mechanically connected to a second end of the first terminal element to form a contact element, and such that a second end of the second terminal element protrudes out of the housing to allow the contact element to be electrically contacted from the outside. A first seal is arranged within the opening in the cover of the housing, the first seal being configured to seal the opening such that gases are prevented from entering the housing through the opening.

The invention may be better understood with reference to the following drawings and the description. The components in the figures are not necessarily to scale, emphasis instead being placed upon illustrating the principles of the invention. Moreover, in the figures, like reference numerals designate corresponding parts throughout the different views.

### BRIEF DESCRIPTION OF THE DRAWINGS

Figure 1 is a cross-sectional view of an example of a power semiconductor module with a housing.
Figure 2 is a cross-sectional view of a further example of a power semiconductor module with a housing.
Figure 3, including Figures 3A and 3B, exemplarily illustrates a detailed view of a connection between a housing and a semiconductor substrate.
Figure 4 is a cross-sectional view of a further example of a power semiconductor module with a housing.
Figure 5 is a cross-sectional view of a further example of a power semiconductor module with a housing.
Figure 6 is a cross-sectional view of a further example of a power semiconductor module with a housing.
Figure 7 is a cross-sectional view of a further example of a power semiconductor module with a housing.
Figure 8 is a cross-sectional view of a further example of a power semiconductor module with a housing.
Figure 9 is a cross-sectional view of a further example of a power semiconductor module with a housing.
Figure 10, including Figures 10A to 10F, schematically illustrates a method for producing a device for protecting a power semiconductor module arrangement
Figure 11 is a cross-sectional view of a further example of a power semiconductor module with a housing.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

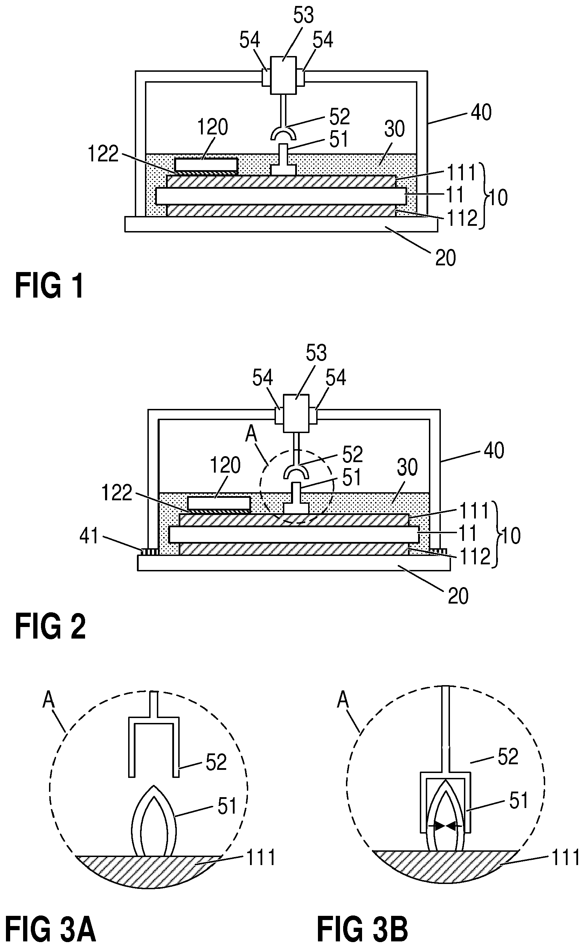

Referring to Figure 1, a cross-sectional view of an exemplary power semiconductor module is illustrated. The power semiconductor module includes a housing 40 and a semiconductor substrate 10. The semiconductor substrate 10 includes a dielectric insulation layer 11, a (structured) first metallization layer 111 attached to the dielectric insulation layer 11, and a second (structured) metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminium; an aluminium alloy; any other metal or alloy that remains solid during the operation of the power semiconductor module arrangement. The semiconductor substrate 10 may be a ceramic substrate, that is, a substrate in which the dielectric insulation layer 11 is a ceramic, e.g., a thin ceramic layer. The ceramic may consist of or include one of the following materials: aluminium oxide; aluminium nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may be, e.g., a Direct Copper Bonding (DCB) substrate, a Direct Aluminium Bonding (DAB) substrate, or an Active Metal Brazing (AMB) substrate. The substrate 10 may also be a conventional printed circuit board (PCB) having a non-ceramic dielectric insulation layer 11. For instance, a non-ceramic dielectric insulation layer 11 may consist of or include a cured resin.

The semiconductor substrate 10 is arranged in a housing 40. In the example illustrated in Figure 1, the semiconductor substrate 10 is further arranged on a base plate 20 which forms a ground surface of the housing 40, while the housing 40 itself solely comprises sidewalls and a cover. In the example in Figure 1, only one semiconductor substrate 10 is arranged on the base plate 20. In some power semiconductor modules, more than one semiconductor substrate 10 may be arranged on a single base plate 20. The base plate 20 may include a metal or a metal alloy such as copper or AlSiC, for example. AlSiC is a metal matrix composite consisting of an aluminium matrix with silicon carbide particles. Copper is often used for industrial applications, while AlSiC is used for traction applications, for example. The semiconductor substrate 10 may be connected to the base plate 20 by means of a connection layer (not illustrated in Figure 1). Such a connection layer may be a solder layer, a layer of an electrically conductive adhesive, or a layer of a sintered metal powder, e.g., a sintered silver powder, for example.

One or more semiconductor bodies 120 may be arranged on the semiconductor substrate 10. Each of the semiconductor bodies 120 arranged on the semiconductor substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable semiconductor element.

The one or more semiconductor bodies 120 may form a semiconductor arrangement on the semiconductor substrate 10. In Figure 1, only one semiconductor body 120 is exemplarily illustrated. The second metallization layer 112 of the semiconductor substrate 10 in Figure 1 is a continuous layer. The first metallization layer 111 of the example in Figure 1 is also a continuous layer. However, the first metallization layer 111, the second metallization layer 112 or both may also be structured layers. "Structured layer" means that, e.g., the first metallization layer 111 is not a continuous layer, but includes recesses between different sections of the layer. Different semiconductor bodies 120 may be mounted to the same or to different sections of the first metallization layer 111. Different sections of the first metallization layer 111 may have no electrical connection or may be electrically connected to one or more other sections using, e.g., bonding wires. Electrical connections may also include connection plates or conductor rails, for example, to name just a few examples. The one or more semiconductor bodies 120 may be electrically and mechanically connected to the semiconductor substrate 10 by an electrically conductive connection layer 122. Such an electrically conductive connection layer 122 may be a solder layer, a layer of an electrically conductive adhesive, or a layer of a sintered metal powder, e.g., a sintered silver powder, for example.

The power semiconductor module further includes a first terminal element 51. The first terminal element 51 is electrically connected to the semiconductor substrate 10, e.g., to the first metallization layer 111 of the semiconductor substrate 10, and forms a part of a contact element which provides an electrical connection between the inside and the outside of the housing 40. A first end of the first terminal element 51 may be electrically and mechanically connected to the first metallization layer 111 by an electrically conductive connection layer (not illustrated). Such an electrically conductive connection layer may be a solder layer, a layer of an electrically conductive adhesive, or a layer of a sintered metal powder, e.g., a sintered silver powder, for example. The power semiconductor module includes a second terminal element 52, 53 which forms a further part of the contact element. A first end 52 of the second terminal element protrudes into the housing 40 and is configured to be electrically and mechanically connected to a second end of the first terminal element 51. A second end 53 of the second terminal element protrudes out of the housing 40 to allow the contact element to be electrically contacted from the outside. The housing 40 comprises an opening through which the second terminal element 52, 53 protrudes such that its first side 52 is inside the housing 40 and its second side 53 is outside the housing 40. The opening may be arranged in a cover or top portion of the housing 40 such that the second terminal element 52, 53 protrudes vertically into the housing 40 when the housing 40 is mounted to a power semiconductor module.

The above mentioned components, as well as other components of the semiconductor arrangement inside the housing 40, may corrode when they come into contact with corrosive gases, for example. Corrosive gases may include, e.g., sulfur or sulfur-containing compounds. Corrosive gases in the surrounding area of the power semiconductor module may penetrate into the housing 40 if the housing 40 is not sufficiently sealed. Inside the housing 40, the corrosive gases may form acids or solutions, for example, in combination with moisture that is present inside the housing 40. The corrosive gases or the resulting solutions may cause a corrosion of some or all of the components. During the corrosion process, the metallic constituents of the components may be oxidized to their respective sulfides. The sulfide formation may alter the electrical properties of the components or may result in the formation of new conductive connections and in short circuits within the power semiconductor module.

Examples for corrosive gases are hydrogen sulfide (H₂S), carbonyl sulfide (OCS), or gaseous sulfur (Ss). Generally, it is also possible that sulfur will enter the inside of the housing 40 as a constituent of a solid material or liquid.

Components including one or more metals such as copper (e.g., first metallization layer 111, terminal elements 51, 52, 53, connection layers, chip pad metallization), silver (e.g., first metallization layer 111, electrical connections, terminal elements 51, 52, 53, connection layers, chip pad metallization), or lead (e.g. connection layers including leaded solder), may be particularly sensitive to corrosion. Other metals such as aluminium, for example, may have a thin oxide layer covering their surface area, which may provide at least a certain amount of protection against corrosive gases.

The opening in the housing 40 through which the second terminal element 52, 53 protrudes provides a potential place of entry for corrosive gases. Therefore, the second terminal element 52, 53 may be held in place by a first seal 54. The first seal 54 may be inserted into the opening of the housing 40 such that it surrounds the second terminal element 52, 53. In this way, the first seal 54 not only holds the second terminal element 52, 53 in place, but also seals the opening of the housing 40. The first seal 54 is firmly squeezed between the second terminal element 52, 53 and the housing 40 such that the opening is completely sealed. The opening may be circular and the first seal 54 may be ring-shaped, for example. Any other shapes, however, are also possible. For example, the opening and the first seal 54 may have a square shape. The shape of the opening and the first seal 54 may correspond to a shape of the second terminal element 52, 53. For example, a cross section of the second terminal element 52, 53 may have a round shape or a square shape. Any other shapes are also possible.

The first seal 54 may comprise a liquid crystal polymer (LCP) such as an aramid or aramid fibers, for example. Aramid fibers are a class of heat-resistant and strong synthetic fibers. Aramid fibers are fibers in which the chain molecules are highly oriented along the fiber axis, so the strength of the chemical bond can be exploited. For example, the aramid may be an AABB polymer such as Kevlar, for example. Kevlar is a p-phenylene terephtalamide (PPTA), which is the simplest form of the AABB para-polyaramide. PPTA is a product of p-phenylene diamine (PPD) and terephthaloyl dichlorine (TDC or TCI). The production of PPTA relies on a co-solvent with an ionic component (calcium chloride CaCl₂) to occupy the hydrogen bonds of the amide groups, and an organic component (N-methyl pyrrolidone NMP) to dissolve the aromatic polymer. Kevlar itself is gas-tight with a coefficient of diffusion for water that is about 100 times lower than other known thermoplastic materials such as, e.g., PBT. Kevlar has a certain elasticity and is deformable to a certain degree. This allows a seal 54 including Kevlar to be tightly squeezed into the gap which remains after inserting the second terminal element 52, 53 through the opening of the housing 40.

For example, the first seal 54 may be wedge-shaped or conical, with its narrow end protruding into the housing 40 and the broad end protruding out of the housing 40. When the second terminal element 52, 53 is connected to the first terminal element 51 (as is exemplarily illustrated with reference to Figure 3 below), the seal 54, together with the second terminal element 52, 53, is pulled towards the first terminal element 51 to a certain degree. This means that the first seal 54 is pulled towards the inside of the housing 40, with a part of the first seal 54 usually still protruding out of the housing. In this way, the opening may be adequately sealed by the resulting contact pressure, such that gasses may not enter the housing 40. A wedge-shaped or conical seal 54, however, is only an example. It is, for example, also possible that the opening comprise a thread. The seal 54 may also comprise a suitable thread such that it may be screwed into the opening and is securely held in place in the opening. Another possibility would be to inject the material, e.g., Kevlar, into the opening with the second terminal element 52, 53 arranged therein. These are, however, only examples. The first seal 54 may also be fixed in the opening of the housing 40 in any other suitable way.

A power semiconductor module usually further includes a casting compound 30. The casting compound 30 may consist of or include a silicone gel or may be a rigid molding compound, for example. The casting compound 30 may at least partly fill the interior of the housing 40, thereby covering the components and electrical connections that are arranged on the semiconductor substrate 10. The first terminal element 51 may be partly embedded in the casting compound 30. At least the second end of the first terminal element 51, however, may not be covered by the casting compound 30 and may protrude from the casting compound 30. The casting compound 30 is configured to protect the components and electrical connections inside the power semiconductor module, in particular inside the housing 40, from certain environmental conditions, mechanical damage and insulation faults. However, corrosive gases are usually able to penetrate through the casting compound 30. The casting compound 30, therefore, is usually not able to protect the components and electrical connections from corrosive gases. This is why a sealed housing 40 is provided, to prevent (corrosive) gases from entering the housing 40.

The housing 40 may be a ceramic housing, for example. The sidewalls and the cover of the housing 40 may comprise a single layer of a ceramic material, for example. Ceramic housings are usually comparably rigid and stiff. Therefore, ceramic housings 40 may be disadvantageous in certain cases, e.g., for bigger power semiconductor modules. Bigger power semiconductor modules may have housings with a side length of 19cm x 16cm, for example. For such bigger housings it may be difficult to flexibly adapt a ceramic housing to the base plate 20. The housing 40 generally may be mechanically connected to the base plate 20 by means of a first joint 41, which is exemplarily illustrated in Figure 2. The first joint 41 may be a solder joint or a cold welding joint, for example. Any other suitable joints 41 are also possible to mechanically connect the housing 40 to the base plate 20, which also provide a suitable seal such that no, or at least less gasses may enter the housing 40.

Instead of a ceramic material, the housing 40 may include a liquid crystal polymer, for example. A non-ceramic material may be advantageous, for example, for housings with smaller dimensions. Liquid crystal polymer has a comparatively small comparative tracking index (CTI). The CTI is used to measure the electrical breakdown (tracking) properties of an insulating material. Tracking is an electrical breakdown on the surface of an insulating material wherein an initial exposure to heat chars the material, and the char is more conductive than the original insulator, producing more current flow, more heat, and eventually complete failure. If a CTI of > 125V is required, a housing 40 solely including liquid crystal polymer might not be sufficient to meet the requirements. A housing 40, therefore, may comprise more than one layer. This will be discussed again in more detail further below.

The first joint 41 is configured to seal the inside of the housing 40 at the junction between the housing 40 and the base plate 20 at least to a certain degree. The first joint 41 is further configured to hold the housing 40 in place on the base plate 20. However, the housing 40 is further held in place by the contact element including the first terminal element 51 and the second terminal element 52, 53.

For example, the contact element may include a press-fit connection between the first terminal element 51 and the second terminal element 52, 53. Such a press-fit connection is exemplarily illustrated in Figure 3. Figure 3 schematically illustrates a section A of the embodiment illustrated in Figure 2. Figure 3A schematically illustrates the first terminal element 51 and the first end 52 of the second terminal element before connecting the terminal elements to each other. The first terminal element 51 may include or may be a press-fit pin, for example. The first end 52 of the second terminal element may include an appropriate counterpart for the press-fit pin. While not connected to the counterpart, the press-fit pin has a larger width than the counterpart. The width of the press-fit pin is a width in a direction parallel to an upper surface of the semiconductor substrate 10. An upper surface of the semiconductor substrate 10 is a surface on which the first terminal element 51 is mounted. During the press-in process, the press-fit pin is pushed into the counterpart. This results in a plastic deformation of the press-fit pin. When inserted into the counterpart, the width of the press-fit pin is reduced, which is schematically illustrated in Figure 3B by means of arrows. Only small insertion forces are generally necessary with high holding forces at the same time. The press-fit pin and the counterpart, after inserting the press-fit pin, are firmly attached to each other. The reduced width of the press-fit pin results in a force which counteracts the compression of the press-fit pin. The second terminal element 52, 53, therefore, may not be easily detached from the first terminal element 51. The terminal elements 51, 52, 53 may have an appropriate length in a direction perpendicular to the upper surface of the semiconductor substrate 10 such that the housing 40 is at least slightly pulled towards the base plate 20.

A press-fit contact, however, is only an example. Any other suitable connections between the first terminal element 51 and the second terminal element 52, 53 are also possible. For example, the connection may be a spring contact including a contact spring (not illustrated).

In the Figures, the housing 40 is illustrated as being mounted to the base plate 20. The first terminal element 51 and the second terminal element 52, 53, however, are illustrated with a gap between them. It should be recognized that generally in the mounted position of the housing 40, the first terminal element 51 and the second terminal element 52, 53 are connected to each other, as has been described with reference to Figure 3 above. The elements are illustrated in such a manner for illustration purposes only and do not represent the actual condition when correctly assembled.

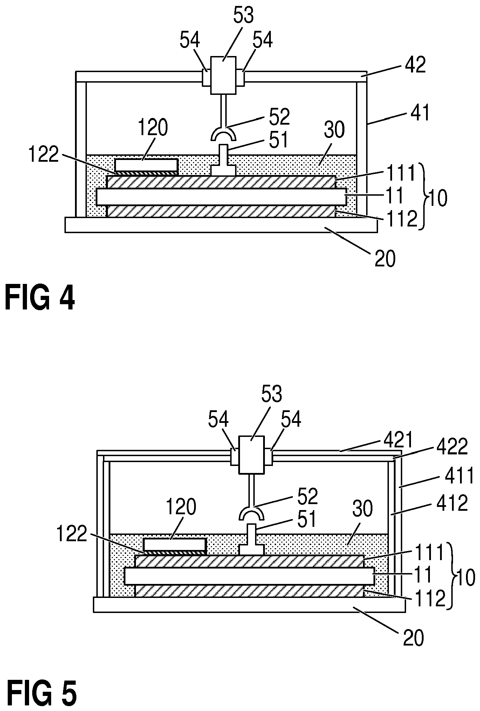

The housing 40 may be provided as a single piece, as is illustrated in Figures 1 and 2, for example. This means that there are no joints between the sidewalls and the cover of the housing 40. It is, however, also possible that the housing include two or more parts, as is exemplarily illustrated in Figure 4. In the example of Figure 4, the sidewalls and the cover are separate parts which are connected to form a housing 40. A housing 40 comprising one or two separate pieces that are connected to each other, however, is only an example. The housing 40 may also comprise any other number of pieces which are connected to each other in a suitable way.

A ceramic housing, as has been exemplarily described above, is only one example. The housing 40 generally may include any suitable material, e.g., a polymer. It is possible that the housing 40 comprise only one layer including a first material, as described with reference to Figures 1, 2 and 4 above. It is, however, also possible that the housing 40 comprises more than one material or more than one layer. This is exemplarily illustrated in Figure 5. In the example of Figure 5, the housing 40 comprises two different layers. A first layer 411, 421 is arranged on the outside of the housing 40 such that it faces the surroundings of the housing, and a second layer 412, 422 is arranged on the inside of the housing 40 such that it faces the interior of the housing 40. Each layer 411, 421, 412, 422 may be a continuous layer (not illustrated). It is, however, also possible that each layer 411, 421, 412, 422 comprise two or more parts. This is exemplarily illustrated in Figure 5. In this example, the first layer 411, 421 comprises two parts, namely a first part 411 forming a portion of the sidewalls of the housing 40, and a second part 421 forming a portion of the cover of the housing 40. The second layer 412, 422 also comprises two parts, namely a first part 412 forming a portion of the sidewalls of the housing 40, and a second part 422 forming a portion of the cover of the housing 40.

The first layer 411, 421 may comprise a first material and the second layer 412, 422 may comprise a second material which is different from the first material. For example, the first material may include a thermoplastic (e.g., polybutylene terephthalate PBT, polyamide PA, polyphthalamide PPA, polyphenylene sulfide PPS) or a thermoset. The second material may include a liquid crystal polymer such as Kevlar, for example. The second material may include the same material as the seal 54, for example. The first layer 411, 421 including the first material forms an outer casing (outer housing), while the second layer 412, 422 including the second material forms an inner casing (inner housing). The inner casing is configured to provide a gas barrier which prevents (corrosive) gases from entering the inside of the housing 40. As has been described above with reference to the first seal 54, liquid crystal polymers (e.g., Kevlar) are gas-tight materials. Such materials, however, may not fulfill the comparative tracking index (CTI) requirements. The comparative tracking index (CTI) may be fulfilled by the use of the outer casing including the first material, for example. Polyamide, for example, has a CTI > 600V. In some applications, a CTI > 400V, or > 500V may be sufficient, while other applications may require a housing 40 with a CTI > 600V.

The housing 40 as described in Figure 5 may be mechanically connected to the base plate 20 by means of a first joint, as has been described with reference to Figure 2 above (first joint not illustrated in Figure 5). The first joint may be a solder joint or a cold welding joint, for example. Any other suitable joints are also possible for mechanically connecting the housing 40 to the base plate 20 that provide a suitable seal such that no, or at least less gas may enter the housing 40.

It is noted that the housing 40 may include a single layer in some parts (e.g., sidewalls) while including two layers in other parts (e.g., cover). For example, the sidewalls could include a single ceramic layer, and the cover may include a first layer 421 and a second layer 422, as has been described above.

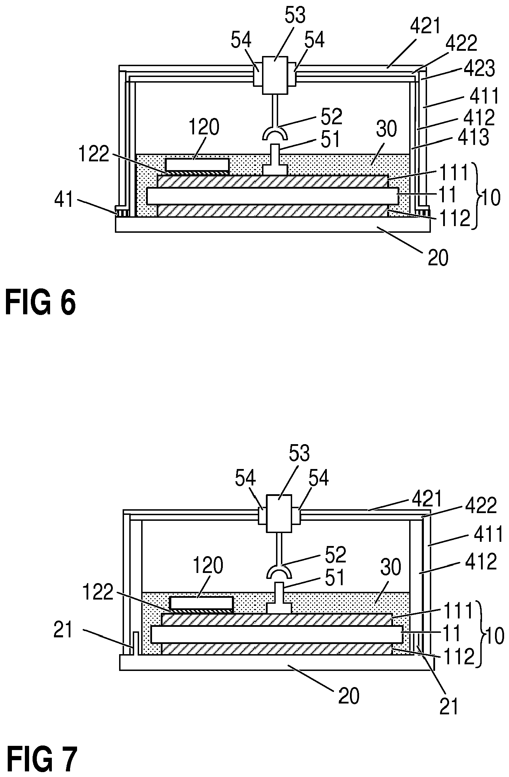

Instead of two layers 411, 412, 421, 422, the housing 40 could also include three layers 411, 412, 413, 421, 422, 423, for example, as is exemplarily illustrated in Figure 6. For example, in addition to the first and second layers 411, 412, 421, 422, the housing 40 may include a third layer 413, 423 which forms the inner casing of the housing 40. The first layer 411, 421 may form the outer casing of the housing 40 as has been described with reference to Figure 5 above. The second layer 412, 422 may be arranged between the first layer 411, 421 and the third layer 413, 423. The second layer 412, 422, therefore, does not come into direct contact with the interior of the housing 40 nor with the outside of the housing 40. In this example, the first layer 411, 421 may include the first material which may include a thermoplastic (e.g., polybutylene terephthalate PBT, polyamide PA, polyphthalamide PPA, polyphenylene sulfide PPS) or a thermoset, for example. The third layer 413, 423 may also include the first material which may include a thermoplastic (e.g., polybutylene terephthalate PBT, polyamide PA, polyphthalamide PPA, polyphenylene sulfide PPS) or a thermoset, for example. The second layer 412, 422 may comprise a third material, which may include a metal, for example. The second layer 412, 422 may be a metal sheet for example. The metal sheet may include copper, for example. In one example, the housing 40 comprises a metal sheet which is overmolded with the first material.

This is, however, only an example. According to another example, the first layer 411, 421 includes a liquid crystal polymer such as Kevlar, for example, which is coated with a metal layer (second layer 412, 422). A further layer of liquid crystal polymer (third layer 413, 423) may then be formed on the metal layer 412, 422. It is, however, also possible that the third layer 413, 423, including a liquid crystal polymer such as Kevlar, for example, be coated with a metal layer (second layer 412, 422) on which the first layer 411, 421 is subsequently formed.

A housing 40 in which the first layer 411, 421 and the third layer 413, 423 both include the same material is only one example. According to another example, the first layer 411, 421 may include a thermoplastic (e.g., polybutylene terephthalate PBT, polyamide PA, polyphthalamide PPA, polyphenylene sulfide PPS) or a thermoset, while the third layer 413, 423 includes a layer of liquid crystal polymer. If the housing 40 is required to have a certain CTI (e.g., >125V), it may be sufficient to provide one layer of a material with the required CTI. However, it might not be necessary to provide two layers of a material with the required CTI.

If the second layer 412, 422 includes a metal sheet, the metal sheet may be left free of the first material and/or second material in some places. For example, the metal sheet may not be covered by the first and/or second material on a narrow side which faces the base plate 20. In this way, a gas-tight joint may be formed between the housing and the base plate 20, for example. The joint may be a joint as has been described with reference to Figure 2 above, for example. Further, the metal sheet may not be covered by the first and/or second material on a narrow side facing the opening in the housing 40 through which the contact element 51, 52, 53 protrudes. Generally speaking, the first material may be applied to the second layer 412, 422 such that there is no direct connection between the first layer 411, 421 on the outside of the housing 40 and the third layer 413, 423 on the inside of the housing 40. A direct connection between the first layer 411, 421 and the third layer 413, 423 might allow moisture which is present on the outside of the housing 40 to diffuse into the housing 40.

The second layer 412, 422 in the example of Figure 6 may function as the gas barrier. Metals are generally gas-tight. Further, e.g., steam generally cannot pass through metal barriers. As has been described with reference to Figure 5 above, different parts of the housing 40 may comprise a different number of layers. As is illustrated in Figure 6, the sidewalls include a first layer 411, a second layer 412 and a third layer 413. Further, the cover also includes a first layer 421, a second layer 422 and a third layer 423. However, it is also possible that the cover includes three layers 421, 422, 423 and the sidewalls include only a single layer 411 or two layers 411, 412. According to further examples, the sidewalls include three layers 411, 412, 413 and the cover includes a single layer 421 or two layers 422, 423. Any other number of layers is also possible. The cover may be connected to the sidewalls by means of further joints (not illustrated). Such further joints could include a solder joint or a cold welding joint, for example.

According to one example, the sidewalls include a single layer 411 including ceramic, and the cover includes three layers 421, 422, 423, with the second layer 422 including a metal, as has been described with respect to Figure 6 above. The sidewalls may be soldered or welded to the base plate 20, for example. The sidewalls may further be soldered or welded to the cover, for example. A surface of the sidewalls facing the base plate 20 may be metal-plated (e.g., nickel-plated or copper-plated). The same applies to a surface of the sidewalls facing the cover. Further, a surface of the base plate 20 facing the sidewalls may be metal-plated (e.g., nickel-plated or copper-plated), and a surface of the cover facing the sidewalls may be metal-plated (e.g., nickel-plated or copper-plated). This allows the sidewalls to be soldered or welded to the base plate 20 and the cover, for example.

According to a further example, the metal layer may not be a continuous layer which extends through the sidewalls and the cover of the housing 40. As is exemplarily illustrated in Figure 7, the base plate 20 may include protrusions 21, which extend into one of the layers of a double layered housing 40. For example, the second layer 412, 422 of a double layered housing 40 may comprise recesses. The protrusions 21 may be inserted into those recesses when mounting the housing 40 to the base plate 20. Such a solution may not require any additional joints (see, e.g., first joints 41 in Figure 2). The housing 40 may be held in place by pushing the housing 40 onto the protrusions 21. Further, the contact element 51, 52, 53 keeps the housing in place 40 after arranging it on the base plate 20. However, it is also possible to provide further joints between the housing 40 and the base plate 20. For example, the first layer 411, 421 may additionally be glued to the base plate 20. For example, a silicone adhesive may be used to provide a joint between the base plate 20 and the first layer 411, 421. The protrusions 21 may comprise the same material as the base plate 20 or may comprise a different material. For example, the protrusions 21 may include a metal sheet.

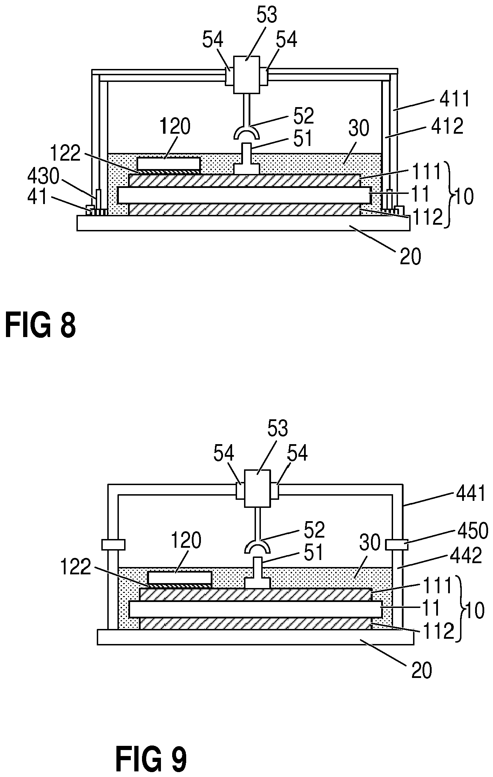

In the example of Figure 7, the protrusions 21 are an integral part of the base plate 20. It is, however, also possible that a separate metal sheet 430 be provided, as is exemplarily illustrated in Figure 8. The metal sheet 430 may form a part of the housing 40. For example, the metal sheet 430 may be arranged between the first layer 411 and the second layer 412 of the sidewall. However, as compared to the exemplary embodiment of Figure 6, the metal sheet 430 may only be arranged between the first layer 411 and the second layer 412 in some parts. For example, the metal sheet 430 may only be provided in a lower part of the sidewalls which is arranged close to the base plate 20 when the housing 40 and the base plate 20 are connected to each other. In other parts of the sidewalls no metal sheet may be provided between the first layer 411 and the second layer 412 such that the first layer 411 and the second layer 412 are arranged adjacent to each other in some parts. This means that in a lower part of the sidewalls which is to be arranged close to the base plate 20, the sidewall may have three layers (first layer 411, metal sheet 430, second layer 412), and in an upper part of the sidewalls which is arranged close to the cover of the housing 40, the sidewalls may have only two layers (first layer 411, second layer 412). The cover of the housing 40 may have two layers, for example.

As has been described above, the power semiconductor module generally further includes a casting compound 30. The casting compound 30 may consist of or include a silicone gel or may be a rigid molding compound, for example. The casting compound 30 may at least partly fill the interior of the housing 40, thereby covering the components and electrical connections that are arranged on the semiconductor substrate 10. The casting compound 30 generally is provided in a liquid or viscous form. It is poured over the semiconductor substrate 10 and the semiconductor arrangement arranged thereon. A casting mold is usually used to provide a frame for the casting compound 30. The casting compound 30 is then heated/dried and at least some of the liquid constituents and/or volatile constituents (e.g., so-called volatile organic compounds VOC) are evaporated. This hardens the casting compound 30 at least to a certain degree. The casting mold may then be removed and the semiconductor module arrangement may be sealed with the housing 40. This process is usually quite cumbersome.

Therefore, the package 40 may include an upper part 441 and a lower part 442. The upper part 441 may include the cover of the housing 40 and a part of the sidewalls which is arranged adjacent to the cover. The lower part 442 may include a part of the sidewalls which is arranged adjacent to the base plate 20. According to another example, the upper part 441 includes the cover of the housing 40 and the lower part 442 includes the sidewalls of the housing, for example. In this way, it is possible to first arrange the lower part 442 on the base plate 20 and permanently connect the lower part 442 to the base plate 20. One or more semiconductor substrates 10 may be arranged on the base plate 20. One or more semiconductor bodies 120 may be arranged on the one or more semiconductor substrates 10. All necessary electrical connections between the semiconductor bodies 120 and the semiconductor substrates 10 may be formed before applying the casting compound 30. A first terminal element 51 may be provided on at least one of the semiconductor substrates 10. The lower part 442 may form or function as the casting mold. This means that the casting compound 30 may be filled into the frame which is formed by the lower part 442 of the housing 40. The casting compound 30 may then be dried/heated in a drying step, as has been explained above. As the lower part 442 of the housing 40 acts as the casting mold as well as a part of the housing 40, the lower part 442 does not need to be removed from the base plate 20 after drying the casting compound 30.

To close the housing, the upper part 441 of the housing 40 may be arranged on the lower part 442. For example, a second seal 450 may be provided between the upper part 441 and the lower part 442. The second seal 450 may include a liquid crystal polymer (LCP) such as an aramid or aramid fibers, for example. For example, the aramid may be an AABB polymer such as Kevlar, for example. As has been explained above, Kevlar itself is gas-tight, has a certain elasticity and is deformable to a certain degree. Therefore, when arranging the upper part 441 on the lower part 442 of the housing 40, the upper part 441 is pushed in the direction of the base plate 20 and squeezes the second seal 450 to a certain degree. When the connection is made between the first terminal element 51 and the second terminal element 52, 53, the second seal 450 is tightly squeezed between the upper part 441 and the lower part 442, thereby adequately sealing the housing 40.

Such a second seal 450 may be provided for housings 40 with a single layer 411 as well as for housings 40 with two or more layers. Further, a second seal 450 could be used in the embodiments of Figures 7 and 8. The presence of a second seal 450 does not depend on the number of layers, the material of the layers or on any other features of the housing 40. The second seal 450 decouples the lower part 442 of the housing 40 from the upper part 441 of the housing 40 to a certain degree. This may reduce the tensions resulting from thermomechanical stress of the power semiconductor module. Further stress and tensions on the power semiconductor module may be created when the base plate 20 is mounted to a heat sink, for example. The stiffer the housing 40, the higher the stress will be. This is because the base plate 20 is deformed when it is mounted to the heat sink. This stress may be transferred to the power semiconductor module and the housing 40, which are connected to the base plate 20. Depending on the expected stress and tensions and the expected deformation of the housing 40, the contact element including the first terminal element 51 and the second terminal element 52, 53 may be dimensioned. The more extensive the contact element, the better the pressure distribution on the (metallic) contact areas as compared to small contact areas.

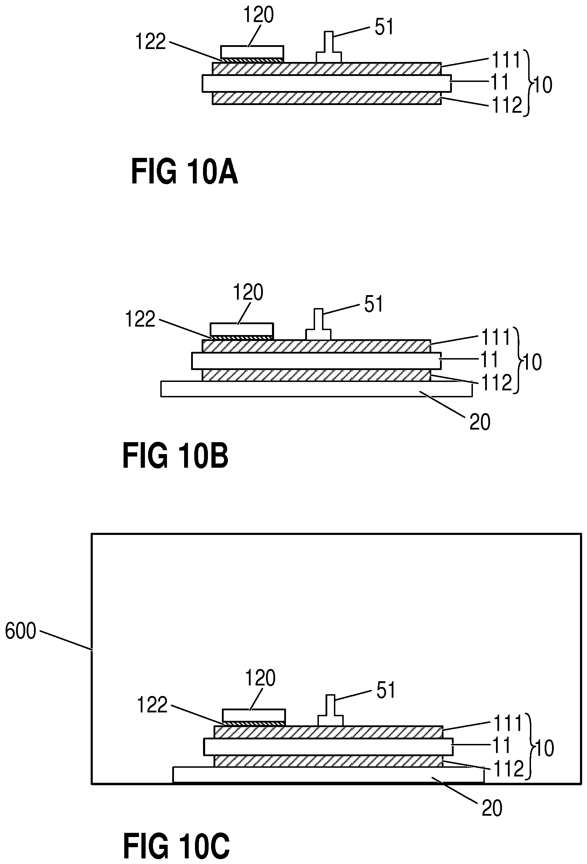

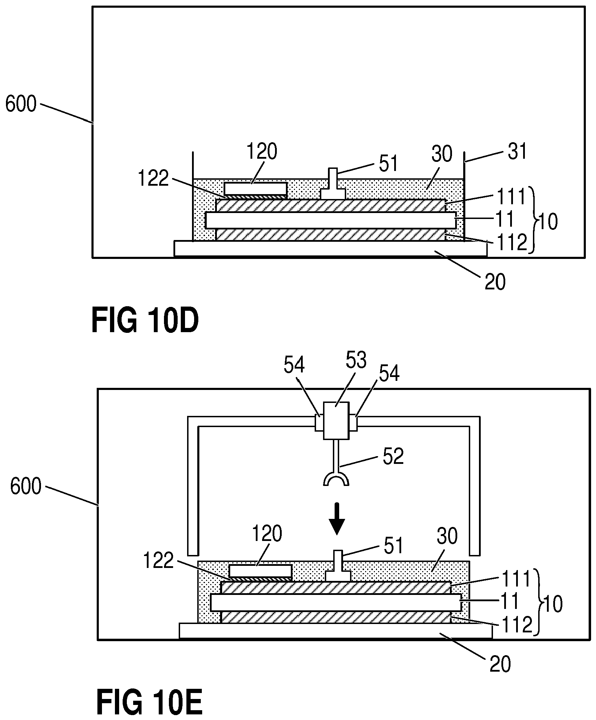

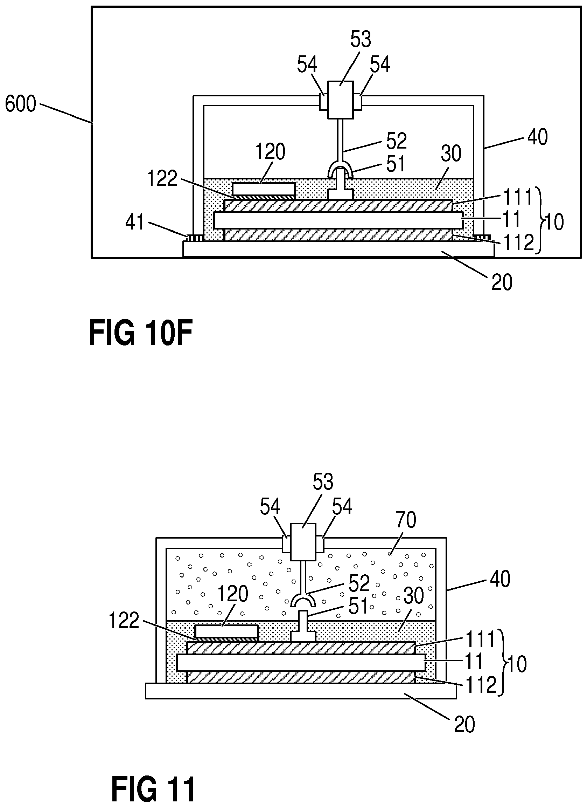

The housing 40 may be sealed in a vacuum chamber. Often power semiconductor modules are placed in a vacuum chamber to form the casting compound 30. The same vacuum chamber could be used for both steps, namely for forming the casting compound 30 and for subsequently sealing the housing 40. An exemplary method for producing a power semiconductor module is schematically illustrated in Figure 10. First, the power semiconductor arrangement including one or more semiconductor bodies 120, one or more electrical connections and the first terminal element 51, may be arranged on the semiconductor substrate 10, as is schematically illustrated in Figure 10A. The semiconductor substrate 10 may then be mounted to a base plate 20, as is schematically illustrated in Figure 10B. The base plate 20 with the semiconductor substrate 10 arranged thereon may then be placed in a vacuum chamber 600, as is schematically illustrated in Figure 10C. A casting mold 31 may be provided to form the casting compound 30, as is schematically illustrated in Figure 10D. As has been described above, the casting mold 31 could be formed by a lower part 442 of the housing 40, for example. For example, a silicone material may then be poured into the casting mold 31. Any other suitable materials are also possible. A negative pressure of, e.g., 15 mbar may be present in the vacuum chamber 600 when pouring the material into the casting mold 31. The (silicone) material may then be degassed, e.g., at a negative pressure of about 10 mbar. During the degassing process, the casting compound 30 may be freed of any residual moisture and of oxygen. The casting mold 31 may then be removed and the housing 40 may be mounted to the base plate 20 (see Figure 10E).

For example, after forming and optionally degassing the casting compound 30 at first, lower negative pressures, the vacuum chamber 600 may subsequently be filled with a gas such as nitrogen, helium, or a nitrogen-helium mixture, for example. At the same time, the negative pressure within the vacuum chamber 600 may be raised to a second negative pressure which is higher than the first negative pressures. For example, the negative pressure within the vacuum chamber 600 may be increased to about 500 mbar. The second terminal element 52, 53 may already be inserted into the cover of the housing 40 before mounting the housing 40 to the base plate 20, as is illustrated in Figure 10E. When arranging the housing 40 on the base plate 20, a connection is established between the first terminal element 51 and the second terminal element 52, 53, as has been described above (see Figure 10F). Further, a first joint 41 may optionally be formed between the housing 40 and the base plate 20 or a junction between an upper part 441 and a lower part 442 of the housing 40 may be sealed. In a next step, the sealed housing 40 may be baked at a temperature of, e.g., 150 °C, or more.

If the substrate 10 is not removed from the vacuum chamber 600 between the steps of forming the casting compound 30 and sealing the housing 40, the casting compound 30 will never come into direct contact with air at atmospheric pressure, in particular, not after hardening the casting compound 30. This results in a very low remaining quantity of oxygen and /or moisture resolved within the casting compound 30. If the power semiconductor arrangement is removed from the vacuum chamber 600 before mounting the housing 40, it might be necessary to subsequently evacuate the casting compound 30. Exposing the casting compound 30 to atmospheric pressure may lead to delamination effects. This means that the casting compound 30 may detach from the components (e.g., semiconductor bodies 120) that it is supposed to cover.

When mounting the housing 40 to the base plate 20, a vacuum may be created inside the housing 40. The vacuum (negative pressure) within the sealed housing 40 may be dependent on the operating temperature of the power semiconductor module arrangement. The higher the operating temperatures, the lower the vacuum within the housing 40 will be, for example. This may prevent an overpressure within the housing 40 when the power semiconductor module arrangement is operated at high operating temperatures. For example, a negative pressure below 800 mbar, below 700 mbar, below 600 mbar, or even below 500 mbar and down to 1 mbar may be created inside the housing 40.

Optionally, the housing 40 may be dried in a drying step before mounting the housing 40 to the base plate 20. This might be preferable, for example, if a material is used for the housing 40 that is able to store a certain amount of moisture. The moisture may be removed or at least reduced by performing a drying step, especially if the material that may store moisture is used as an inner casing of the housing 40. Moisture that is stored in an inner casing of the housing 40 may be released, e.g., when the power semiconductor module is subsequently stored at relatively high temperatures or when an operating temperature is relatively high. If the outer casing of the housing stores a certain amount of moisture this is generally not problematic, as long as the outer casing does not have a direct contact to the inner casing (e.g., metal barrier between inner and outer casing).

The remaining volume inside the housing 40 may be filled with a gas 70, for example. Possible gasses 70 include sulfur hexafluoride SF₆, for example. SF₆ has very good insulating properties. Other possible gasses include dry nitrogen, for example, possibly with a small quantity of helium. A nitrogen-helium mixture may be advantageous when a leakage test is performed after sealing the housing 40. This will be described in greater detail further below.

The negative pressure inside the housing 40 helps to further seal the housing 40. The vacuum inside the housing 40 results in the seals, e.g., first seal 54, second seal 450, being pulled inwards to a certain degree. Especially if the seals are wedge-shaped or conical, with their narrow ends protruding into the housing 40 and the broad ends protruding out of the housing 40, this results in a very good gas tightness.

As has been stated above, a leakage test may be performed after sealing the housing 40. This is exemplarily illustrated in Figure 11. In the embodiment that is exemplarily illustrated in Figure 11, the inside of the housing is filled with gas 70. The gas 70 may be a nitrogen-helium mixture, for example. Helium, for example may be easily detected. After sealing the housing 40, the power semiconductor module may be removed from the vacuum chamber 600. A sensor which is able to detect helium may be placed next to the housing 40. If any helium is detected, this indicates that the housing is not sufficiently sealed. If any helium (or other detectable gas) can leak out of the housing 40, (corrosive) gases may also leak into the housing 40. If it is detected that the gas 70 is leaking out of the housing 40, the power semiconductor module may be rejected. Using helium or a helium mixture as the gas 70 to fill the housing 40 is only an example. Any other detectable gases may be used instead.

## Claims

1. A power semiconductor module comprising:
at least one semiconductor substrate (10) comprising a dielectric insulation layer (11), a first metallization layer (111) attached to the dielectric insulation layer (11), and a second metallization layer (112) attached to the dielectric insulation layer (11), wherein the dielectric insulation layer (11) is disposed between the first and second metallization layers (111, 112);
a power semiconductor arrangement arranged on the at least one semiconductor substrate (10), wherein the power semiconductor arrangement includes at least one first terminal element (51) and wherein the first terminal element (51) is connected to the semiconductor substrate (10) with a first end;
a base plate (20), wherein the semiconductor substrate (10) is arranged on the base plate (20);
a housing (40) that is configured to enclose the semiconductor substrate (10) and that is configured to be connected to the base plate (20), the housing (40) comprising sidewalls and a cover, wherein the cover comprises an opening; and
a second terminal element (52, 53) that is arranged within the opening in the cover of the housing (40) such that a first end (52) of the second terminal element protrudes into the housing (40), the first end (52) being configured to be electrically and mechanically connected to a second end of the first terminal element (51) to form a contact element, and such that a second end (53) of the second terminal element protrudes out of the housing (40) to allow the contact element to be electrically contacted from the outside, wherein
a first seal (54) is arranged within the opening in the cover of the housing (40), the first seal (54) being configured to seal the opening such that gases are prevented from entering the housing (40) through the opening.

2. The power semiconductor module of claim 1, wherein the first seal (54) comprises a liquid crystal polymer (LCP), an aramid or aramid fibers.

3. The power semiconductor module of claim 2, wherein the first seal (54) includes Kevlar.

4. The power semiconductor module of any of claims 1 to 3, wherein at least one of
the first seal (54) is wedge-shaped or conical, with its narrow end protruding into the housing (40) and the broad end protruding out of the housing (40);
the opening and the first seal (54) each comprise a thread and the first seal (54) is configured to be screwed into the opening such that it is securely held in place in the opening;
the first seal (54) is formed by injecting material into the opening.

5. The power semiconductor module of any of claims 1 to 4, wherein at least one of
the contact element formed by the first terminal element (51) and the second terminal element (52, 53) is configured to hold the housing (40) down on the base plate (20); and
the contact element formed by the first terminal element (51) and the second terminal element (52, 53) is configured to pull the first seal (54) into the opening and towards the inside of the housing (40) to firmly seal the opening.

6. The power semiconductor module of any of the preceding claims, wherein at least one of
the housing (40) at least partially is a single layered housing, comprising, in the respective parts, a single layer (411, 421) including a first material;
the housing (40) at least partially is a double layered housing, comprising, in the respective parts, a first layer (411, 421) including a first material and a second layer (412, 422) including a second material; and
the housing (40) at least partially is a three layered housing, comprising, in the respective parts, a first layer (411, 421) including a first material, a second layer (412, 422) including a second material and a third layer (413, 423) including a third material.

7. The power semiconductor module of claim 6, wherein at least one of
the first material comprises a ceramic, a polymer, a thermoplastic, a thermoset or a liquid crystal polymer;
the second material comprises a metal, a polymer, a thermoplastic, a thermoset or a liquid crystal polymer; and
the third material comprises a polymer, a thermoplastic, a thermoset or a liquid crystal polymer.

8. The power semiconductor module of any of the preceding claims, wherein the contact element comprises a press-fit connection or a spring contact between the first terminal element (51) and the second terminal element (52, 53).

9. The power semiconductor module of any of the preceding claims, wherein the housing (40) is divided in an upper part (441) and a lower part (442), wherein the upper part (441) comprises at least the cover of the housing (40), and the lower part (442) comprises at least a part of the sidewalls.

10. The power semiconductor module of claim 9, wherein a second seal (450) is arranged between the upper part (441) and the lower part (442).

11. The power semiconductor module of claim 10, wherein the second seal (450) comprises a liquid crystal polymer.

12. The power semiconductor module of any of claims 9 to 11, wherein the lower part (442) is configured to form a casting mold.

13. The power semiconductor module of any of the preceding claims, further comprising a gas (70) inside the housing (40).

14. A housing (40) for a power semiconductor module, wherein the housing (40) is configured to be connected to a base plate (20) and to enclose a power semiconductor arrangement arranged on a substrate (10), and wherein the housing (40) comprises:
sidewalls and a cover with an opening; and
a second terminal element (52, 53) that is arranged within the opening in the cover of the housing (40) such that a first end (52) of the second terminal element protrudes into the housing (40), the first end (52) being configured to be electrically and mechanically connected to a second end of a first terminal element (51) of the power semiconductor arrangement to form a contact element, and such that a second end (53) of the second terminal element protrudes out of the housing (40) to allow the contact element to be electrically contacted from the outside, wherein
a first seal (54) is arranged within the opening in the cover of the housing (40), the first seal (54) being configured to seal the opening such that gases are prevented from entering the housing (40) through the opening.

15. A method for producing a power semiconductor module, the method comprising
arranging a power semiconductor arrangement on at least one semiconductor substrate (10), wherein the semiconductor substrate (10) comprises a dielectric insulation layer (11), a first metallization layer (111) attached to the dielectric insulation layer (11), and a second metallization layer (112) attached to the dielectric insulation layer (11), the dielectric insulation layer (11) being disposed between the first and second metallization layers (111, 112), and wherein the power semiconductor arrangement includes at least one first terminal element (51) that is connected to the semiconductor substrate (10) with a first end;
mounting the semiconductor substrate (10) to a base plate (20);
placing the base plate (20) with the semiconductor substrate (10) in a vacuum chamber (600);
forming a casting compound (30) covering the power semiconductor arrangement arranged on the semiconductor substrate (10); and
mounting a housing (40) to the base plate (20) such that it encloses the semiconductor substrate (10), the housing (40) comprising
sidewalls and a cover with an opening; and
a second terminal element (52, 53) that is arranged within the opening in the cover of the housing (40) such that a first end (52) of the second terminal element protrudes into the housing (40), the first end (52) being configured to be electrically and mechanically connected to a second end of the first terminal element (51) to form a contact element, and such that a second end (53) of the second terminal element protrudes out of the housing (40) to allow the contact element to be electrically contacted from the outside, wherein a first seal (54) is arranged within the opening in the cover of the housing (40), the first seal (54) being configured to seal the opening such that gases are prevented from entering the housing (40) through the opening.

## Amended claims

### Amended claims in accordance with Rule 137(2) EPC.

1. A power semiconductor module comprising:
at least one semiconductor substrate (10) comprising a dielectric insulation layer (11), a first metallization layer (111) attached to the dielectric insulation layer (11), and a second metallization layer (112) attached to the dielectric insulation layer (11), wherein the dielectric insulation layer (11) is disposed between the first and second metallization layers (111, 112);
a power semiconductor arrangement arranged on the at least one semiconductor substrate (10), wherein the power semiconductor arrangement includes at least one first terminal element (51) and wherein the first terminal element (51) is connected to the semiconductor substrate (10) with a first end;
a base plate (20), wherein the semiconductor substrate (10) is arranged on the base plate (20);
a housing (40) that is configured to enclose the semiconductor substrate (10) and that is configured to be connected to the base plate (20), the housing (40) comprising sidewalls and a cover, wherein the cover comprises an opening; and
a second terminal element (52, 53) that is arranged within the opening in the cover of the housing (40) such that a first end (52) of the second terminal element protrudes into the housing (40), the first end (52) being configured to be electrically and mechanically connected to a second end of the first terminal element (51) to form a contact element, and such that a second end (53) of the second terminal element protrudes out of the housing (40) to allow the contact element to be electrically contacted from the outside, wherein
a first seal (54) is arranged within the opening in the cover of the housing (40), the first seal (54) being configured to seal the opening such that gases are prevented from entering the housing (40) through the opening, and wherein at least one of
the housing (40) at least partially is a double layered housing, comprising, in the respective parts, a first layer (411, 421) including a first material and a second layer (412, 422) including a second material; and
the housing (40) at least partially is a three layered housing, comprising, in the respective parts, a first layer (411, 421) including a first material, a second layer (412, 422) including a second material and a third layer (413, 423) including a third material.

2. The power semiconductor module of claim 1, wherein the first seal (54) comprises a liquid crystal polymer (LCP), an aramid or aramid fibers.

3. The power semiconductor module of claim 2, wherein the first seal (54) includes Kevlar.

4. The power semiconductor module of any of claims 1 to 3, wherein at least one of
the first seal (54) is wedge-shaped or conical, with its narrow end protruding into the housing (40) and the broad end protruding out of the housing (40);
the opening and the first seal (54) each comprise a thread and the first seal (54) is configured to be screwed into the opening such that it is securely held in place in the opening;
the first seal (54) is formed by injecting material into the opening.

5. The power semiconductor module of any of claims 1 to 4, wherein at least one of
the contact element formed by the first terminal element (51) and the second terminal element (52, 53) is configured to hold the housing (40) down on the base plate (20); and
the contact element formed by the first terminal element (51) and the second terminal element (52, 53) is configured to pull the first seal (54) into the opening and towards the inside of the housing (40) to firmly seal the opening.

6. The power semiconductor module of claim 5, wherein at least one of
the first material comprises a ceramic, a polymer, a thermoplastic, a thermoset or a liquid crystal polymer;
the second material comprises a metal, a polymer, a thermoplastic, a thermoset or a liquid crystal polymer; and
the third material comprises a polymer, a thermoplastic, a thermoset or a liquid crystal polymer.

7. The power semiconductor module of any of the preceding claims, wherein the contact element comprises a press-fit connection or a spring contact between the first terminal element (51) and the second terminal element (52, 53).

8. The power semiconductor module of any of the preceding claims, wherein the housing (40) is divided in an upper part (441) and a lower part (442), wherein the upper part (441) comprises at least the cover of the housing (40), and the lower part (442) comprises at least a part of the sidewalls.

9. The power semiconductor module of claim 8, wherein a second seal (450) is arranged between the upper part (441) and the lower part (442).

10. The power semiconductor module of claim 9, wherein the second seal (450) comprises a liquid crystal polymer.

11. The power semiconductor module of any of claims 8 to 10, wherein the lower part (442) is configured to form a casting mold.

12. The power semiconductor module of any of the preceding claims, further comprising a gas (70) inside the housing (40).

13. A housing (40) for a power semiconductor module, wherein the housing (40) is configured to be connected to a base plate (20) and to enclose a power semiconductor arrangement arranged on a substrate (10), and wherein the housing (40) comprises:
sidewalls and a cover with an opening; and
a second terminal element (52, 53) that is arranged within the opening in the cover of the housing (40) such that a first end (52) of the second terminal element protrudes into the housing (40), the first end (52) being configured to be electrically and mechanically connected to a second end of a first terminal element (51) of the power semiconductor arrangement to form a contact element, and such that a second end (53) of the second terminal element protrudes out of the housing (40) to allow the contact element to be electrically contacted from the outside, wherein
a first seal (54) is arranged within the opening in the cover of the housing (40), the first seal (54) being configured to seal the opening such that gases are prevented from entering the housing (40) through the opening, and wherein at least one of
the housing (40) at least partially is a double layered housing, comprising, in the respective parts, a first layer (411, 421) including a first material and a second layer (412, 422) including a second material; and
the housing (40) at least partially is a three layered housing, comprising, in the respective parts, a first layer (411, 421) including a first material, a second layer (412, 422) including a second material and a third layer (413, 423) including a third material.

14. A method for producing a power semiconductor module, the method comprising
arranging a power semiconductor arrangement on at least one semiconductor substrate (10), wherein the semiconductor substrate (10) comprises a dielectric insulation layer (11), a first metallization layer (111) attached to the dielectric insulation layer (11), and a second metallization layer (112) attached to the dielectric insulation layer (11), the dielectric insulation layer (11) being disposed between the first and second metallization layers (111, 112), and wherein the power semiconductor arrangement includes at least one first terminal element (51) that is connected to the semiconductor substrate (10) with a first end;
mounting the semiconductor substrate (10) to a base plate (20);
placing the base plate (20) with the semiconductor substrate (10) in a vacuum chamber (600);
forming a casting compound (30) covering the power semiconductor arrangement arranged on the semiconductor substrate (10); and
mounting a housing (40) to the base plate (20) such that it encloses the semiconductor substrate (10), the housing (40) comprising
sidewalls and a cover with an opening; and
a second terminal element (52, 53) that is arranged within the opening in the cover of the housing (40) such that a first end (52) of the second terminal element protrudes into the housing (40), the first end (52) being configured to be electrically and mechanically connected to a second end of the first terminal element (51) to form a contact element, and such that a second end (53) of the second terminal element protrudes out of the housing (40) to allow the contact element to be electrically contacted from the outside, wherein
a first seal (54) is arranged within the opening in the cover of the housing (40), the first seal (54) being configured to seal the opening such that gases are prevented from entering the housing (40) through the opening, and wherein at least one of
the housing (40) at least partially is a double layered housing, comprising, in the
respective parts, a first layer (411, 421) including a first material and a second layer (412, 422) including a second material; and
the housing (40) at least partially is a three layered housing, comprising, in the respective parts, a first layer (411, 421) including a first material, a second layer (412, 422) including a second material and a third layer (413, 423) including a third material.
